# EUROPEAN PATENT APPLICATION

(11) **EP 2 367 207 A2**
(43) Date of publication of application: **21.09.2011**
(21) Application number: 11157071.9
(22) Date of filing: 04.03.2011
(51) Int. Cl.: H01L 31/0216, H01L 31/0236, H01L 31/052

(54) **Thin film solar cell and manufacturing method thereof**

(30) Priority: 17.03.2010 TW 099107834; 17.03.2010 TW 099107836
(71) Applicant: Auria Solar Co., Ltd., Tainan 74146 (TW)
(72) Inventor: Tsai, Chin-Yao, 80336, Munich (TW)
(74) Representative: Brandenburger, Karin

(57) **Abstract**

A thin-film solar cell and a manufacture method thereof are provided. The thin-film solar cell comprises a transparent substrate, a first transparent conductive layer, a photovoltaic layer, a second transparent conductive layer and a light reflecting structure. The transparent substrate has a light incident surface and a back surface opposite to the light incident surface. The first transparent conductive layer is disposed on the back surface of the transparent substrate. The photovoltaic layer is disposed on the first transparent conductive layer. The second transparent conductive layer is disposed on the photovoltaic layer. The light reflecting structure is disposed on the second transparent conductive layer. The manufacture method forms the light reflecting structure having a texture structure on the thin film to enhance utilization of light beams in the thin-film solar cell so as to further improve photoelectric conversion efficiency of the thin-film solar cell.

## Description

### BACKGROUND OF THE INVENTION

### Field of the Invention

The present invention relates to a solar cell and a manufacturing method thereof, and more particularly, to a thin-film solar cell with improved photoelectric conversion efficiency and a manufacturing method thereof.

### Descriptions of the Related Art

Due to shortage of fossil energy resources and enhanced awareness of environmental protection, great efforts have been made continuously in recent years on development and research of technologies related to alternative energy resources and renewable energy resources. This is intended to reduce the level of dependence on fossil energy resources and influence of consumption of fossil energy resources on the environment. Among various technologies related to alternative energy resources and renewable energy resources, the solar cell has received the most attention. This is mainly because that the solar cell can convert the solar energy directly into the electric energy without emission of hazardous materials that may pollute the environment such as carbon dioxide or nitrides during electric power generation.

Generally, a conventional thin-film solar cell is typically formed by sequentially stacking an electrode layer, a photoelectric conversion layer and an electrode layer throughout a substrate. When light rays from the outside impinge on the thin-film solar cell, the photoelectric conversion layer irradiated by the light rays is adapted to generate free electron-hole pairs. Under action of a built-in electric field formed by the PN junction, the electrons and the holes migrate towards the two electrode layers respectively to result in an electric energy storage status. Then, if a load circuit or an electronic device is externally connected across the solar cell, the electric energy can be supplied to drive the load circuit or the electronic device.

However, thin-film solar cells currently available have photoelectric conversion efficiency as low as about 6%~10% on average, and currently there still exists a bottleneck in improving the photoelectric conversion efficiency of the thin-film solar cells. Accordingly, efforts still have to be made in the art to provide a solution that can improve the photoelectric conversion efficiency of the thin-film solar cells.

### SUMMARY OF THE INVENTION

The present invention provides a thin-film solar cell, which can enhance the utilization factor of light beams to improve the photoelectric conversion efficiency of the thin-film solar cell.

The thin-film solar cell of the present invention comprises a transparent substrate, a first transparent conductive layer, a photovoltaic layer, a second transparent conductive layer and a light reflecting structure. The transparent substrate has a light incident surface and a light exiting surface opposite to the light incident surface. The first transparent conductive layer is disposed on the light exiting surface of the transparent substrate. The photovoltaic layer is disposed on the first transparent conductive layer. The second transparent conductive layer is disposed on the photovoltaic layer. The light reflecting structure is disposed on the second transparent conductive layer, wherein a light beam enters the thin-film solar cell via the light incident surface, passes sequentially through the transparent substrate, the first transparent conductive layer, the photovoltaic layer and the second transparent conductive layer and then into the light reflecting structure, and the light reflecting structure reflects the light beam.

In an embodiment of the present invention, the light reflecting structure comprises a patterned structure. The patterned structure has a first sub-pattern structure and a second sub-pattern structure. The first sub-pattern structure is disposed on the second transparent conductive layer, the second sub-pattern structure is disposed on the first sub-pattern structure, and the second sub-pattern structure at least partially overlaps the first sub-pattern structure.

In an embodiment of the present invention, the patterned structure may be of a straight stripe form, a stripe form, a transverse stripe form, a check form, a rhombus form, a honeycomb form or a mosaic form.

In an embodiment of the present invention, a surface where the first sub-pattern structure makes contact with the second transparent conductive layer is a texture structure.

In an embodiment of the present invention, at least a surface where the second sub-pattern structure makes contact with the first sub-pattern structure is a texture structure.

In an embodiment of the present invention, the light reflecting structure is a light reflecting structure layer, and the light reflecting structure layer is integrally formed.

In an embodiment of the present invention, the light reflecting structure layer entirely or partially covers the second transparent conductive layer.

In an embodiment of the present invention, a surface where the light reflecting structure layer makes contact with the second transparent conductive layer is a texture structure.

In an embodiment of the present invention, the light reflecting structure is made of one or more materials selected from a group consisting of a white paint, a metal, a metal oxide and an organic material.

In an embodiment of the present invention, the metal is selected from a group consisting of aluminum (A1), scandium (Sc), titanium (Ti), vanadium (V), chromium (Cr), manganese (Mn), iron (Fe), cobalt (Co), nickel (Ni), copper (Cu), zinc (Zn), gallium (Ga), germanium (Ge), yttrium (Y), zirconium (Zr), niobium (Nb), molybdenum (Mo), technetium (Tc), ruthenium (Ru), rhodium (Rh), palladium (Pd), silver (Ag), cadmium (Cd), indium (In), tin (Sn), antimony (Sb), lanthanum (La), gadolinium (Gd), hafnium (Hf), tantalum (Ta), tungsten (W), rhenium (Re), osmium (Os), iridium (Ir), platinum (Pt), gold (Au), thallium (Tl), lead (Pb) and alloys thereof.

In an embodiment of the present invention, the metal oxide comprises an indium oxide, a tin oxide, a silicon oxide, a magnesium fluoride, a tantalum oxide, a titanium oxide, a magnesium oxide, a zirconium oxide, a silicon nitride, an aluminum oxide, a hafnium oxide, a indium tin oxide (ITO), a cadmium stannate (Cd2SnO4 a cadmium stannate doped with copper, a stannic oxide or a stannic oxide doped with fluorine.

In an embodiment of the present invention, the organic material comprises a dye or a pigment.

In an embodiment of the present invention, a part of the light beam comprises a red light, a near infrared (IR) light or a far IR light.

In an embodiment of the present invention, the photovoltaic layer is a group IV element thin film, a group III-V compound semiconductor thin film, a group II-VI compound semiconductor thin film, an organic compound semiconductor thin film or a combination thereof.

In an embodiment of the present invention, the group IV element thin film comprises at least one of an α-Si thin film, a µc-Si thin film, an a-SiGe thin film, a µc-SiGe thin film, an a-SiC thin film, a µc-SiC thin film, a tandem group IV element thin film or a triple group IV element thin film.

In an embodiment of the present invention, the group III-V compound semiconductor thin film comprises gallium arsenide (GaAs), indium gallium phosphide (InGaP) or a combination thereof.

In an embodiment of the present invention, the group II-VI compound semiconductor thin film comprises copper indium selenium (CIS), copper indium gallium selenium (CIGS), cadmium telluride (CdTe) or a combination thereof.

In an embodiment of the present invention, the organic compound semiconductor thin films comprise a mixture of poly(3-hexylthiophene) (P3HT) and carbon nanospheres (PCBM).

In an embodiment of the present invention, the transparent substrate is a glass substrate.

According to the above descriptions, the thin-film solar cell of the present invention has a light reflecting structure disposed on the second transparent conductive layer to increase the opportunity for the light beam to be reflected in the thin-film solar cell. This can prolong the light path of the light beam in the photovoltaic layer so that the light beam will be more likely absorbed by the photovoltaic layer to generate more electron-hole pairs. In other words, the thin-film solar cell employing the light reflecting structure can effectively enhance the utilization factor ofthe light beam to improve the photoelectric conversion efficiency thereof.

The present invention also provides a method for manufacturing a thin-film solar cell, which can form a light reflecting structure having a texture structure on a layer. This can enhance the utilization factor of the light beam in the thin-film solar cell, thus resulting in improved photoelectric conversion efficiency of the thin-film solar cell.

The method for manufacturing a thin-film solar cell of the present invention comprises the following steps of: providing a transparent substrate; forming a first transparent conductive layer on the transparent substrate; forming a photovoltaic layer on the first transparent conductive layer; forming a second transparent conductive layer on the photovoltaic layer; and forming a light reflecting structure having a texture structure on the second transparent conductive layer.

In an embodiment of the present invention, the light reflecting structure is formed through an impression process.

In an embodiment of the present invention, the impression process comprises: forming a reflective material layer on the second transparent conductive layer entirely; and impressing a mold with a texture pattern onto the reflective material layer to form the light reflecting structure having the texture structure.

In an embodiment of the present invention, the impression process comprises: forming a transparent material layer on the second transparent conductive layer entirely; impressing a mold with a texture pattern onto the transparent material layer to form the texture structure on the surface of the transparent material layer; and forming a reflective material layer on the transparent material layer.

In an embodiment of the present invention, the reflective material layer is conformal to the transparent material layer.

In an embodiment of the present invention, the impression process comprises: impressing a first sub-pattern structure on the second transparent conductive layer; and impressing a second sub-pattern structure on the first sub-pattern structure, wherein the second sub-pattern structure at least partially overlaps the first sub-pattern structure to form the light reflecting structure.

In an embodiment of the present invention, the light reflecting structure may be of a straight stripe form, a stripe form, a transverse stripe form, a check form, a rhombus form, a honeycomb form or a mosaic form.

In an embodiment of the present invention, the light reflecting structure is formed through a mesh process.

In an embodiment of the present invention, the mesh process comprises: disposing a mold having a mesh pattern on the second transparent conductive layer, wherein the mesh pattern has a plurality of openings exposing the second transparent conductive layer; forming a reflective material layer on the mold, wherein portions of the reflective material layer is filled into the openings to connect to the second transparent conductive layer; and removing the mold to form the light reflecting structure having the texture structure.

In an embodiment of the present invention, the mesh process comprises: forming a transparent material layer on the second transparent conductive layer entirely; impressing a mold with a mesh pattern onto the transparent material layer to form the mesh pattern on a surface of the transparent material layer; removing the mold; and forming a reflective material layer on the transparent material layer.

In an embodiment of the present invention, the mesh process comprises: disposing a first mold with a first mesh pattern on the second transparent conductive layer, wherein the first mesh pattern has a plurality of first openings exposing the second transparent conductive layer; forming a first sub-pattern structure on the first mold, wherein the first sub-pattern structure connects with portions of the second transparent conductive layer; disposing a second mold with a second mesh pattern on the first sub-pattern structure, wherein the second mesh pattern has a plurality of second openings exposing at least portions of the first openings; and forming a second sub-pattern structure on the first sub-pattern structure, wherein the second sub-pattern structure at least partially overlaps the first sub-pattern structure to form the light reflecting structures.

In an embodiment of the present invention, the organic material comprises a dye or a pigment.

In an embodiment of the present invention, the transparent substrate has a light incident surface, wherein a light beam enters the thin-film solar cell via the light incident surface, passes sequentially through the transparent substrate, the first transparent conductive layer, the photovoltaic layer and the second transparent conductive layer and then into the light reflecting structure. The light reflecting structure reflects the light beam.

In an embodiment of the present invention, the method for manufacturing a thin-film solar cell further comprises covering an adhesive layer on the light reflective structure to package a counter transparent substrate and the transparent substrate together.

According to the above descriptions, the method for manufacturing a thin-film solar cell of the present invention forms a light reflecting structure having a texture structure on the second transparent conductive layer to increase the opportunity for the light beam to be reflected in the thin-film solar cell. This can prolong the light path of the light beam in the photovoltaic layer so that the light beam will be more likely absorbed by the photovoltaic layer to generate more electron-hole pairs. In other words, the method for manufacturing a thin-film solar cell of the present invention can effectively enhance the utilization factor of the light beam in the resulting thin-film solar cell, thus improving the photoelectric conversion efficiency of the thin-film solar cell.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG. 1** is a schematic cross-sectional view of a thin-film solar cell according to an embodiment of the present invention;
**FIGs. 2A** to **2D** are schematic top views of a light reflecting structure according to different embodiments of the present invention;
**FIG. 3** is a schematic cross-sectional view of a thin-film solar cell according to another embodiment of the present invention;
**FIG. 4** is a schematic cross-sectional view of a thin-film solar cell according to another embodiment of the present invention;
**FIG. 5** is a schematic cross-sectional view of a thin-film solar cell according to another embodiment ofthe present invention;
**FIG. 6** is a schematic cross-sectional view of a thin-film solar cell according to another embodiment ofthe present invention;
**FIG. 7** is a schematic cross-sectional view of a thin-film solar cell according to another embodiment of the present invention;
**FIGs. 8A** to **8D** are schematic cross-sectional views illustrating a manufacturing process of a thin-film solar cell according to an embodiment of the present invention;
**FIGs. 9A** to **9D** are schematic cross-sectional views illustrating a manufacturing process of a thin-film solar cell according to another embodiment of the present invention;
**FIGs. 10A** to **10C** are schematic cross-sectional views illustrating a manufacturing process of a thin-film solar cell according to another embodiment ofthe present invention;
**FIGs. 11A** and **11B** are schematic cross-sectional views illustrating a manufacturing process of a thin-film solar cell according to another embodiment ofthe present invention;
**FIGs. 12A** to **12D** are schematic cross-sectional views illustrating a manufacturing process of a thin-film solar cell according to another embodiment of the present invention;
**FIGs. 13A** to **13D** are schematic cross-sectional views illustrating a manufacturing process of a thin-film solar cell according to another embodiment of the present invention; and
**FIGs. 14A** to **14E** are schematic cross-sectional views illustrating a manufacturing process of a thin-film solar cell according to another embodiment of the present invention.

### DESCRIPTION OF THE PREFERRED EMBODIMENT

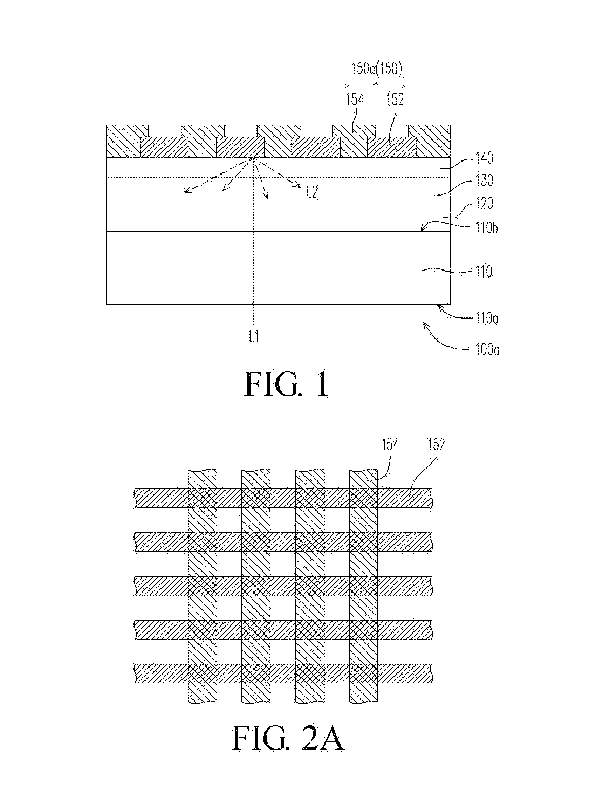

**FIG. 1** is a schematic cross-sectional view of a thin-film solar cell according to an embodiment of the present invention. Referring to **FIG** 1, in this embodiment, the thin-film solar cell **100a** comprises a transparent substrate **110,** a first transparent conductive **layer 120,** a photovoltaic layer **130,** a second transparent conductive layer **140** and a light reflecting structure **150.**

The transparent substrate **110** has a light incident surface **110a** and a light exiting surface **110b** opposite to the light incident surface **110a:** The transparent substrate **110** is, for example, a glass substrate. The first transparent conductive layer **120** is disposed on the light exiting surface **110b** of the transparent substrate **110.** The photovoltaic layer **130** is disposed on the first transparent conductive layer **120.** The second transparent conductive layer **140** is disposed on the photovoltaic layer **130.** The light reflecting structure **150** is disposed on the second transparent conductive layer **140.** A light beam **L1** enters the thin-film solar cell **100a** via the light incident surface **110a**, passes sequentially through the transparent substrate **110,** the first transparent conductive layer **120,** the photovoltaic layer **130** and the second transparent conductive layer **140** and then into the light reflecting structure **150,** and is reflected by the light reflecting structure **150.**

Generally, the first transparent conductive layer **120** and the second transparent conductive layer **140** may both be made of a transparent conductive material such as indium tin oxide (ITO), indium zinc oxide (IZO), indium tin zinc oxide (ITZO), zinc oxide, aluminum tin oxide (ATO), aluminum zinc oxide (AZO), cadmium indium oxide (CIO), cadmium zinc oxide (CZO), gallium zinc oxide (GZO) and fluorine-doped tin oxide (FTO), or a combination thereof.

The photovoltaic layer **130** may be a group IV element thin film, a group III-V compound semiconductor thin film, a group II-VI compound semiconductor thin film, an organic compound semiconductor thin film or a combination thereof. In detail, the group IV element thin film comprises, for example, at least one of an a-Si thin film, a µc-Si thin film, an a-SiGe thin film, a µc-SiGe thin film, an a-SiC thin film, a µc-SiC thin film, a tandem group IV element thin film (e.g., a stacked silicon thin film) or a triple group IV element thin film. The group III-V compound semiconductor thin film comprises, for example, gallium arsenide (GaAs), indium gallium phosphide (InGaP) or a combination thereof. The group II-VI compound semiconductor thin film comprises, for example, copper indium selenium (CIS), copper indium gallium selenium (CIGS), cadmium telluride (CdTe) or a combination thereof. The organic compound semiconductor thin films comprise, for example, a mixture of poly(3-hexylthiophene) (P3HT) and carbon nanospheres (PCBM).

In other words, the thin-film solar cell **100a** may adopt a layered structure of an amorphous silicon thin-flm solar cell, a microcrystalline silicon thin-film solar cell, a tandem thin-film solar cell, a triple thin-film solar cell, a CIS thin-film solar cell, a CIGS thin-film solar cell, a CdTe thin-film solar cell or an organic thin-film solar cell. That is, depending on the user's design and requirements on the photovoltaic **layer 130,** the thin-film solar cell **100a** of this embodiment may also be of other possible layered structures; and what described above is only for illustration purpose but is not to limit the present invention.

As shown in **FIG. 1****,** the light reflecting structure **150** ofthis embodiment is, for example, a patterned structure **150a.** The patterned structure **150a** comprises a first sub-pattern structure **152** and a second sub-pattern structure **154.** The first sub-pattern structure **152** is disposed on the second transparent conductive layer **140,** and the second sub-pattern structure **154** is disposed on the first sub-pattern structure **152** and at least partially overlaps the first sub-pattern structure **152.** That is, the second sub-pattern structure **154** only partially overlaps the first sub-pattern structure **152;** in other words, portions of the second sub-pattern structure **154** is disposed on the second transparent conductive layer **140.**

Specifically, after entering the thin-film solar cell **100a** via the light incident surface **110a** of the transparent substrate **110,** the light beam L1 sequentially passes through the transparent substrate **110,** the first transparent conductive layer **120** and the photovoltaic layer **130**. Apart of the light beam **L1** that is unabsorbed by the photovoltaic layer **1330** is then transmitted through the second transparent conductive layer **140** to the patterned structure **150a.** Then, the first sub-pattern structure **152** and the second sub-pattern structure **154** of the patterned structure **150a** can reflect a part **L2** of the light beam **L1** to the photovoltaic layer **130.** In this embodiment, the light beam **L2** is, for example, a red light, a near infrared (IR) light or a far IR light.

In other words, by using the stack structure formed by the first sub-pattern structure **152** and the second sub-pattern structure **154** to affect the propagation direction of the light beam **L1,** the light beam **L1** is reflected at the interface between the patterned structure **150a** and the second transparent conductive layer **140.** Thus, the patterned structure **150a** can increase the opportunity for the light beam **1,1** to be reflected in the thin-tilm solar cell 100a. This can prolong the light path of the light beam **L1** in the photovoltaic layer **130** and, consequently, increase the opportunity for the light beam to be absorbed by the photovoltaic layer **130.** As a result, the thin-film solar cell **100a** can effectively utilize and absorb the light beam **L1** and convert it into electric energy, thus resulting in higher photoelectric conversion efficiency.

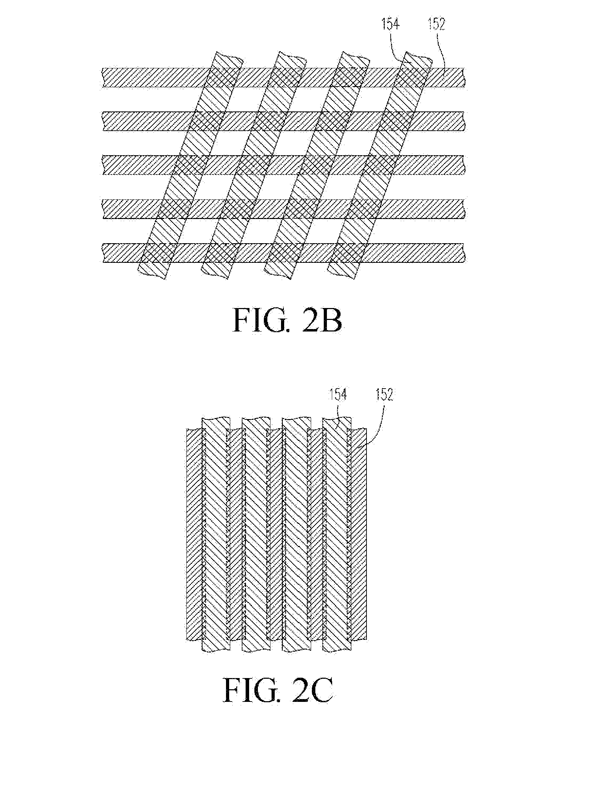

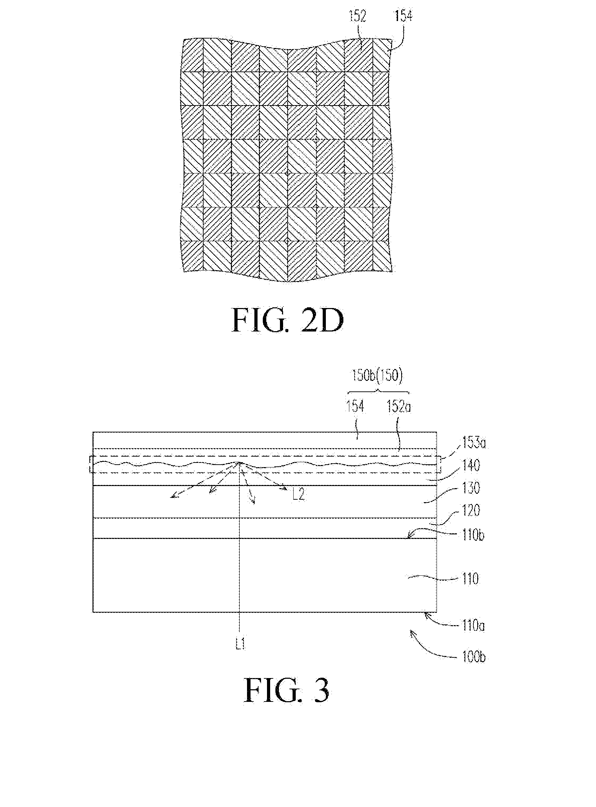

In this embodiment, by modifying the form of the patterned structure **150a** or forming the light reflecting structure **150** of different materials, an objective of reflecting a part **L2** of the light beam **L1** can be achieved. Specifically, the patterned structure **150a** of this embodiment is of, for example, a check form formed by orthogonal intersection of the first sub-pattern structure **152** and the second sub-pattern structure **154** as shown in **FIG. 2A****; a** rhombus form formed by intersection of the first sub-pattern structure **152** and the second sub-pattern structure **154** at an angle as shown in **FIG. 2B****;** a straight stripe form (shown in **FIG. 2C**), a regular or irregular stripe form (not shown) or a transverse stripe form (not shown) formed by parallel arrangement and partial overlapping between the first sub-pattern structure **152** and the second sub-pattern structure **154;** or a mosaic form (shown in **FIG. 2D****)** or a honeycomb form (not shown) formed through regular or irregular arrangement of the first sub-pattern structure **152** and the second sub-pattern structure **154.** In other words, the arrangement and structures of the first sub-pattern structure **152** and the second sub-pattern structure **154** can be varied depending on the user's requirements; and what described above is only for illustration purpose but is not to limit the present invention.

Additionally, the light reflecting structure **150** may be made of one or more materials selected from a group consisting of a white paint, a metal, a metal oxide and an organic material. The metal is selected from a group consisting of aluminum (A1), scandium (Sc), titanium (Ti), vanadium (V), chromium (Cr); manganese (Mn), iron (Fe), cobalt (Co), nickel (Ni), copper (Cu), zinc (Zn), gallium (Ga), germanium (Ge), yttrium (Y), zirconium (Zr), niobium (Nb), molybdenum (Mo), technetium (Tc), ruthenium (Ru), rhodium (Rh), palladium (Pd), silver (Ag), cadmium (Cd), indium (In), tin (Sn), antimony (Sb), lanthanum (La), gadolinium (Gd), hafnium (Ht), tantalum (Ta), tungsten (W), rhenium (Re), osmium (Os), iridium (Ir), platinum (Pt), gold (Au), thallium (Tl), lead (Pb) and alloys thereof. The metal oxide may be selected from an indium oxide, a tin oxide, a silicon oxide, a magnesium fluoride, a tantalum oxide, a titanium oxide, a magnesium oxide, a zirconium oxide, a silicon nitride, an aluminum oxide, a hafnium oxide, a indium tin oxide (ITO), a cadmium stannate (Cd2SnO4), a cadmium stannate doped with copper, a stannic oxide or a stannic oxide doped with fluorine. The organic material may be a dye or a pigment;

Additionally, in an embodiment not shown, the patterned structure may also be a poly-layer formed by a plurality of first polymer materials and a plurality of second polymer materials alternately arranged. The first polymer materials are, for example, hydroxyl acetoxylated polyethylene terephthalate (PET) or a copolymer of hydroxyl acetoxylated polyethylene terephthalate, and the second polymer materials are, for example, polyethylene naphthalate (PEN) or a copolymer of polyethylene naplathalate. However, the materials described above are only provided as examples, and materials that can have the light reflecting structure **150** reflect the light beam all fall within the scope of the present invention.

Hereinbelow, designs of the thin-film solar cells **100b~100f** will be described with reference to several embodiments. It shall be appreciated herein that, some of the reference numerals and contents of the above embodiments apply also to the following embodiments, wherein identical reference numerals are used to denote the same or similar elements, and descriptions of identical technical contents will be omitted. For descriptions of the omitted portions, reference may be made to the aforesaid embodiments.

**FIG. 3** is a schematic cross-sectional view of a thin-film solar cell according to another embodiment of the present invention. Referring to **FIG. 1** and **FIG. 3** together, the thin-film solar cell 100b of this embodiment is similar to the thin-film solar cell **100a** of **FIG.** 1 except that: the light reflecting structure **150** of this embodiment is patterned structure **150b**, and a surface where the first sub-pattern structure **152a** of the patterned structure **150b** makes contact with the second transparent conductive layer **140** is, for example, a texture structure **153a.** To be more specific, the patterned structure **150b** of this embodiment covers the second transparent conductive layer **140** entirely, and the surface where the first sub-pattern structure **152** makes contact with the second transparent conductive layer **140 is** the texture structure **153a** which is, for example, a surface microstructure formed on the surface of the first sub-pattern structure **152a.** Of course, in other embodiments not shown, the texture structure **153a** may also be a surface microstructure formed on the surface of the second transparent conductive layer **140.**

Because the surface where the patterned structure **150b** makes contact with the second transparent conductive layer **140** is a texture structure **153a,** it becomes easier for the light beam **L1** propagating to the texture structure **153a** to be reflected by the texture structure **153a** and for the reflected light beam **L2** to be scattered. This can prolong the light path of the light beam **L2** in the photovoltaic layer **130** and, consequently, increase the opportunity for the light beam **L2** to be absorbed by the photovoltaic layer **130,** thus improving the overall photoelectric conversion efficiency. Furthermore, the part L2 of the light beam **L1** can be reflected directly by the patterned structure **150b** to the photovoltaic layer **130.** In other words, the first sub-pattern structure **152a** and the second sub-pattern structure **154** of the patterned structure **150b** can affect the propagation direction of the light beam **L1** in such a way that the light beam L1 is reflected and scattered by the surface where the first sub-pattern structure **152a** makes contact with the second transparent conductive layer **140** or in such a way that the light beam **L1** is reflected by the second patterned structure **154.** In this way, the opportunity for the light beam **L1** to be reflected in the thin-film solar cell **100b** can be increased to prolong the light path of the light beam **L1** in the photovoltaic layer **130** so that the light beam **L1** will be more likely absorbed by the photovoltaic layer **130** to generate more electron-hole pairs. In other words, the thin-film solar cell **100b** can effectively enhance the utilization factor of the light beam **L1** to improve the photoelectric conversion efficiency.

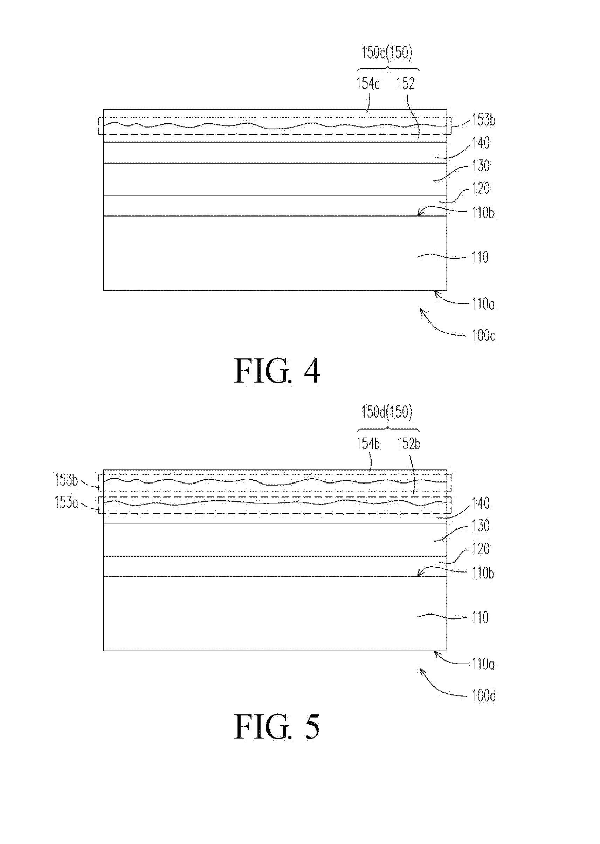

**FIG. 4** is a schematic cross-sectional view of a thin-film solar cell according to another embodiment of the present invention. Referring to **FIG. 3** and **FIG. 4** together, the thin-film solar cell **100c** of this embodiment is similar to the thin-film solar cell **100b** of **FIG. 3** except that: in this embodiment, a surface where the second sub-pattern structure 154b makes contact with the first sub-pattern structure **152** is a texture structure **153b** which is, for example, a surface microstructure formed on the surface of the second sub-pattern structure **154a.** Of course, in other embodiments not shown, the texture structure **153b** may also be a surface microstructure formed on the surface of the first sub-pattern structure **152.**

**FIG. 5** is a schematic cross-sectional view of a thin-film solar cell according to another embodiment of the present invention. Referring to **FIG. 3** and **FIG. 5** together, the thin-film solar cell **100d** of this embodiment is similar to the thin-film solar cell 100b of **FIG. 3** except that: in this embodiment, a surface where the first sub-pattern structure **152b** makes contact with the second transparent conductive layer **140** is, for example, a texture structure **153a,** and a surface where the second sub-pattern structure **154b** makes contact with the first sub-pattern structure **152b** is a texture structure **153b.** The texture structure **153a** is, for example, a surface microstructure formed on the surface of the first sub-pattern structure **152b,** and the texture structure **153b** is, for example, a surface microstructure formed on the surface of the second sub-pattern structure **154b.** Of course, in other embodiments not shown, the texture structure **153a** may also be a surface microstructure formed on the surface of the second transparent conductive layer **140,** and the texture structure **153b** may also be a surface microstructure formed on the surface of the first sub-pattern structure **152b.**

It shall be appreciated herein that, the present invention has no limitation on configurations of the patterned structures **150a~150d**. Although the patterned structures **150a~150d** set forth herein are described to have the first sub-pattern structures **152, 152a, 152b** and the second sub-pattern structures **154, 154a, 154b** (i.e., each of the patterned structures **150a~150d** consists of two layers of patterned structures), other designs capable of achieving the equivalent effect of reflecting a light beam (e.g., the patterned structure is a layer of continuous structure, a layer of discontinuous structure, a plurality of layers of continuous structures or a plurality of discontinuous structures) can also be adopted in the present invention without departing from the scope of the present invention.

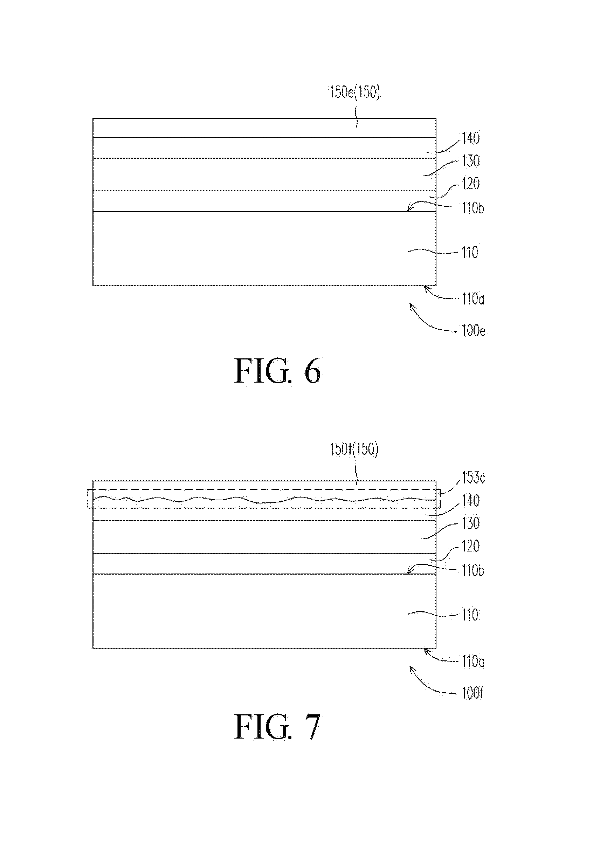

**FIG. 6** is a schematic cross-sectional view of a thin-film solar cell according to another embodiment of the present invention. Referring to **FIG. 1** and **FIG. 6** together, the thin-film solar cell **100e** of this embodiment is similar to the thin-film solar cell **100a** of **FIG. 1** except that, the light reflecting structure **150** of this embodiment is a light reflecting structure layer **150e** and the light reflecting structure layer **150e** is integrally formed. The light reflecting structure layer **150e** covers the second transparent conductive layer **140** entirely to increase the opportunity for the light beam **L1** to be reflected in the thin-film solar **cell 100e.** This can prolong the light path of the light beam **L1** in the photovoltaic layer **130** so that the light beam **L1** will be more likely absorbed by the photovoltaic layer **130** to generate more electron-hole pairs. In other words, the thin-film solar cell **100e** can effectively enhance the utilization factor of the light beam **L1** to improve the photoelectric conversion efficiency thereof.

It is worth noting that, the present invention has no limitation on configurations of the light reflecting structure layer **150e**. Although the light reflecting structure layer **150e** set forth herein is described to entirely cover the second transparent conductive layer 140, other designs capable of achieving the equivalent effect of reflecting a light beam (e.g., the light reflecting structure layer **150e** only partially covers the second transparent conductive layer **140**) can also be adopted in the present invention without departing from the scope of the present invention.

**FIG. 7** is a schematic cross-sectional view of a thin-film solar cell according to another embodiment of the present invention. Referring to **FIG. 6** and **FIG 7** together, the thin-film solar cell 100f of this embodiment is similar to the thin-film solar cell **100e** of **FIG. 6** except that: in this embodiment, a surface where the light reflecting structure layer **150f** makes contact with the second transparent conductive layer **140** is a texture structure **153c** which is, for example, a surface microstructure formed on the surface of the light reflecting structure layer **150f.** Of course, in other embodiments not shown, the texture structure **153c** may also be a surface microstructure formed on the surface of the second transparent conductive layer **140.**

According to the above descriptions, the present invention has a light reflecting structure disposed on the second transparent conductive layer to increase the opportunity for the light beam to be reflected in the thin-film solar cell. This can prolong the light path of the light beam in the photovoltaic layer so that the light beam will be more likely absorbed by the photovoltaic layer to generate more electron-hole pairs. In other words, the thin-film solar cell employing the light reflecting structure can effectively enhance the utilization factor of the light beam to improve the photoelectric conversion efficiency thereof. Furthermore, through design of the texture structure, the light beam can be reflected and scattered to the photovoltaic layer to prolong the light path of the light beam in the photovoltaic layer; this also increases the opportunity for the light beam to be absorbed by the photovoltaic layer to improve the overall photoelectric conversion efficiency.

Hereinbelow, methods for manufacturing a thin-film solar cell will be described with reference to several different embodiments. It shall be appreciated herein that, the following embodiments are intended to disclose methods for manufacturing the aforesaid thin-film solar cells, so some of the reference numerals and contents of the above embodiments will also apply to the following embodiments; in terms of this, identical reference numerals will be used to denote the same or similar elements, and descriptions of identical technical contents (including descriptions of materials of elements, shapes ofthe elements and how the elements are connected) will be omitted. For descriptions of the omitted portions, reference may be made to the aforesaid embodiments of the thin-film solar cell.

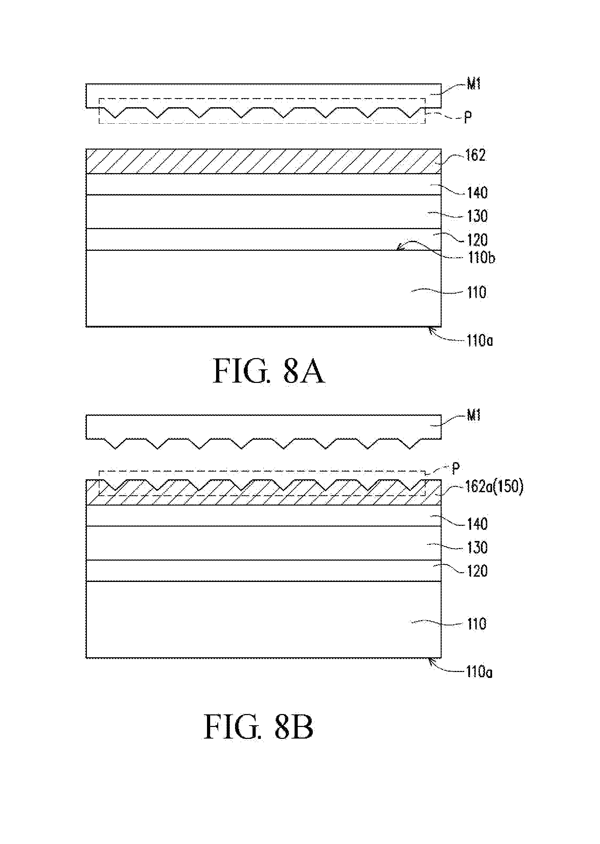

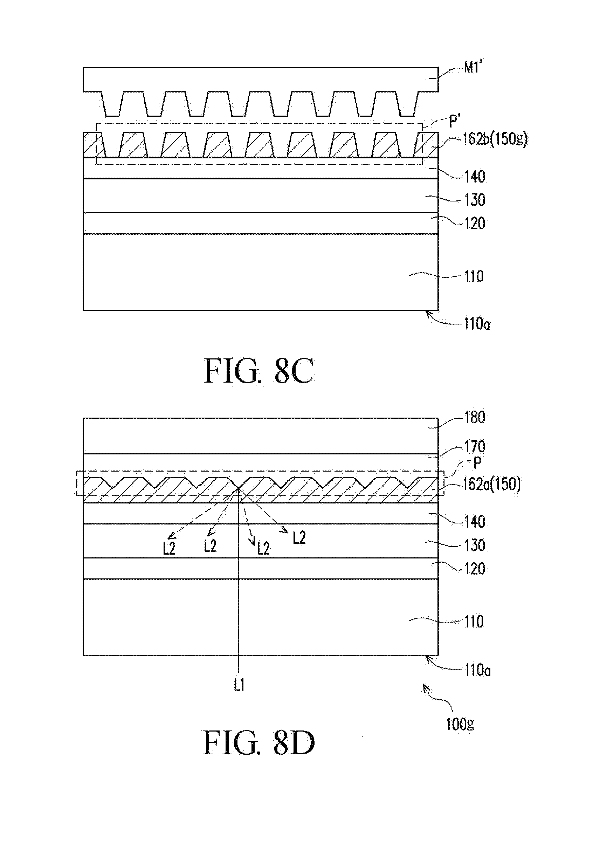

**FIGs. 8A to 8D** are schematic cross-sectional views illustrating a manufacturing process of a thin-film solar cell according to an embodiment of the present invention, in which **FIG. 8C** is a schematic cross-sectional view of forming a light reflecting structure having a texture structure according to another embodiment. Referring to **FIG. 8A****,** firstly, a transparent substrate **110** is provided. The transparent substrate **110,** which is a glass substrate for example, has a light incident surface **110a.** Then, a first transparent conductive layer **120,** a photovoltaic layer **130** and a second transparent conductive layer **140** are sequentially formed on a light exiting surface of the transparent substrate **110** opposite to the light incident surface **110a.**

In this embodiment, the first transparent conductive layer **120** is formed on the transparent substrate **110.** The first transparent conductive layer **120** may be formed through a sputtering process, a metal organic chemical vapor deposition (MOCVD) process or an evaporation process.

Still referring to **FIG. 8A****,** in this embodiment, the photovoltaic layer **130** is formed on the first transparent conductive layer **120.** The photovoltaic layer **130** is formed through, for example, a radio frequency plasma enhanced chemical vapor deposition (RF PECVD) process, a very high frequency plasma enhanced chemical vapor deposition (VHF PECVD) process or a microwave plasma enhanced chemical vapor deposition (MW PECVD) process.

After formation of the photovoltaic layer **130,** the second transparent conductive layer **140** is formed on the photovoltaic layer **130,** as shown in **FIG 8A****.** In this embodiment, the way in which the second transparent conductive layer **140** is formed is the same as way in which the first transparent conductive layer **120 is** formed. Next, referring also to **FIG 8A****,** a reflective material layer **162** is formed on the second transparent conductive layer **140** entirely; i.e., the reflective material layer **162** covers the second transparent conductive layer **140** completely. Thereafter, a mold **M1** having a texture pattern **P** is provided on the reflective material layer **162.**

Afterwards, the mold M1 having the texture pattern **P** is mechanically impressed onto the reflective material layer **162,** as shown in **FIG. 8****B.** Then, the reflective material layer **162a** is cured to form a light reflecting structure **150** having the texture structure **P**. That is, after the impressing with the mold **M** and the curing, the reflective material layer **162a** having the texture structure **P** just serves as the light reflecting structure **150**. Of course, in other embodiments, as shown in **FIG. 8C****,** another kind of light reflecting structure **150g** exposing portions of the second transparent conductive layer **140** may also be formed by impressing a mold **M1'** having a texture pattern **P'** onto the reflective material layer **162.** That is, after the impressing with the mold **M1'** and the curing, the reflective material layer **162b** having the texture structure **P'** and exposing portions of the second transparent conductive layer **140** just serves as the light reflecting structure **150.** As can be known from above, in this embodiment, the light reflecting structures **150, 150g** may be formed through the impression process, wherein the force applied in the mechanical impression process may depend on the configurations ofthe light reflecting structures **150,150g.**

Upon completion of the step shown in **FIG. 8B****,** the mold **M1** is removed and an adhesive layer **170** is applied on the light reflecting structure **150** to package a counter transparent substrate **180** and the transparent substrate **110** together, as shown in **FIG. 8D** In this embodiment, the adhesive layer **170** is made of, for example, an adhesive such as ethylene vinyl acetate (EVA), polyvinyl butyral (PVB), poly olefin or polyurethane (PU). The counter transparent substrate **180** is, for example, a glass substrate. Here, the way of using the adhesive layer **170** to package the transparent substrate **110** and the counter transparent substrate **180** is well known to those of ordinary skill in the art, so no further description will be made thereon. Thus, fabrication of the thin-film solar cell **100g** is substantially completed.

As shown in **FIG. 8D****,** because the thin-film solar cell **100g** of this embodiment comprises the light reflecting structure **150,** the light beam **L1** entering the thin-film solar cell **100g** via the light incident surface **110a** of the transparent substrate **110** sequentially passes through the transparent substrate **110,** the first transparent conductive layer **120** and the photovoltaic layer **130,** and a part of the light beam **L1** unabsorbed by the photovoltaic layer **130** further passes through the second transparent conductive layer **140** to the reflective material layer **162a.** Then, it becomes easier for the light beam **L1** to be reflected by the texture structure **P** ofthe reflective material layer **162a** and for the reflected light beam **L2** to be scattered. This can prolong the light path of the light beam **L2** in the photovoltaic layer **130** and, consequently, increase the opportunity for the light beam **L2** to be absorbed by the photovoltaic layer **130,** thus resulting in improved photoelectric conversion deficiency. Here, the texture structure P reflects and scatters the reflected light beam **L2**, and the light beam **L2** is, for example, a red light, a near IR light or a far IR light.

In other words, by means of the reflective material layer **162a** having the texture structure **P** that can affect the propagation direction of the light beam **L1,** the light beam **L1** is reflected and scattered at the interface between the reflective material layer **162a** and the second transparent conductive layer **140.** Thus, the reflective material layer **162a** can increase the opportunity for the light beam **L1** to be reflected in the thin-film solar cell **100g.** This can prolong the light path of the light beam **L1** in the photovoltaic layer **130** and, consequently, increase the opportunity for the light beam to be absorbed by the photovoltaic layer **130**. In other words, the thin-film solar cell **100g** can effectively absorb the light beam **L1** and convert it into electric energy, thus resulting in higher photoelectric conversion efficiency.

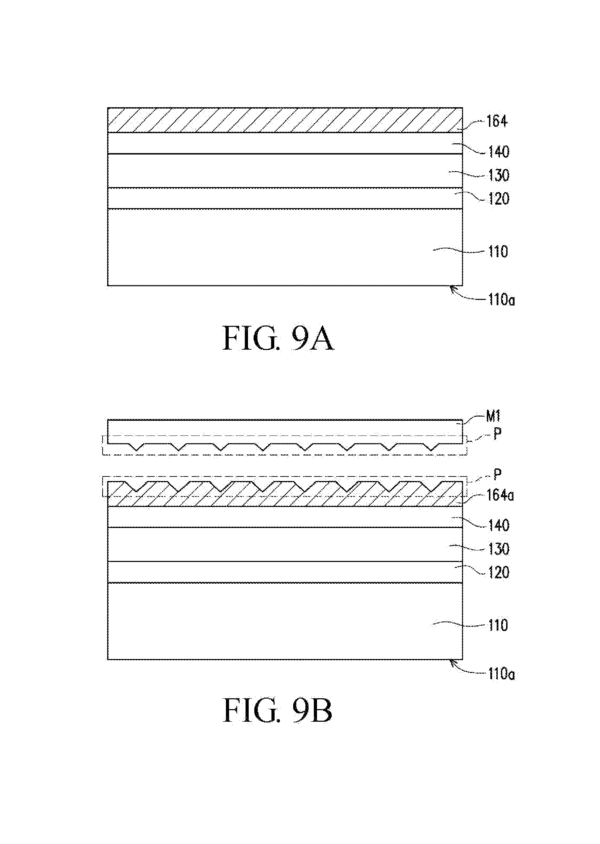

**FIGs. 9A** to **9D** are schematic cross-sectional views illustrating a manufacturing process of a thin-film solar cell according to another embodiment of the present invention. The process of forming the thin-film solar cell **100h** is similar to that of forming the thin-film solar cell **100g**, and differences therebetween will be described below.

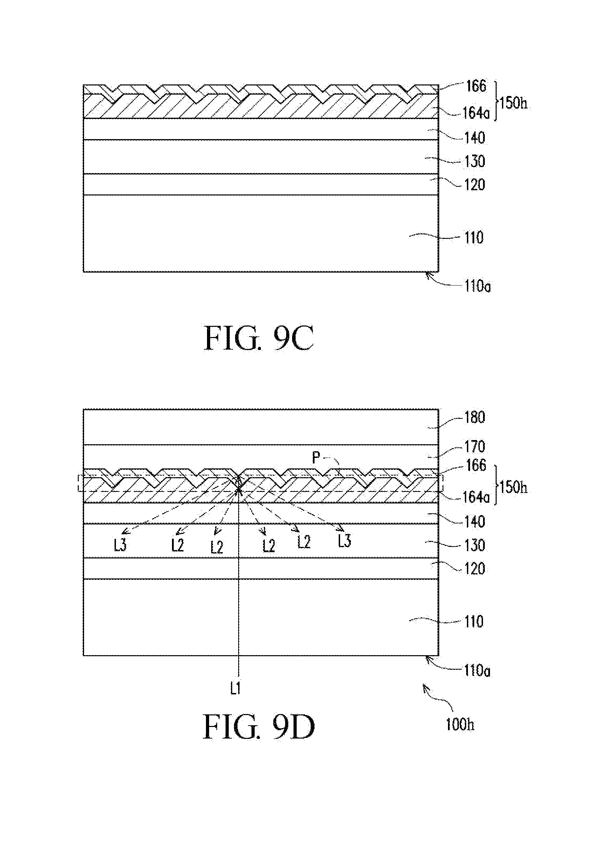

Referring to **FIG. 9A****,** after the second transparent conductive layer **140** is formed on the photovoltaic layer **130,** a transparent material layer **164** is formed on the second transparent conductive layer **140** entirely. Next, as shown in **FIG. 9B****,** a mold **M1** having a texture pattern **P** is impressed onto the transparent material layer **164,** and then the transparent material layer **164a** is cured to form the texture structure **P** on a surface of the transparent material layer **164a.** Then, as shown in **FIG. 9C****,** the mold **M1** is removed and a reflective material layer **166** is formed on the transparent material layer **164a.** The reflective material layer **166** is conformal to the transparent material layer **164a.** Here, the reflective material layer **166** and the transparent material layer **164a** conformal to each other can be viewed as a light reflecting structure **150h.** Thereafter, as shown in **FIG. 9D****,** the adhesive layer **170** is applied onto the light reflecting structure **150h** to package the counter transparent substrate **180** and the transparent substrate **110** together, thus completing the fabrication of the thin-film solar cell **100h.**

In this embodiment, the stack structure formed by the transparent material layer **164a** and the conformal reflective material layer **166** thereon can be viewed as the light reflecting structure **150h,** so when the light beam **L1** propagates to the light reflecting structure **150h,** the texture structure **P** on the surface of the transparent material layer **164a** can also affect the propagation direction of the light beam **L1** in such a way that the light beam **L1** is reflected and scattered at the interface between the transparent material layer **164a and** the second transparent conductive layer **140.** Furthermore, a part of the light beam **L1** that is not reflected and scattered by the texture structure **P** will further pass through the transparent material layer **164a** and be reflected by the reflective material layer **166** as a light beam **L3,** thus prolonging the light paths of the light beams **L2** and **L3** in the photovoltaic layer **130.** This can increase the opportunity for the light beams **L2** and **L3** to be absorbed by the photovoltaic layer **130** to improve overall photoelectric conversion efficiency. In other words, the thin-film solar cell **100h** can effectively absorb the light beam **L1** and convert it into electric energy, thus resulting in higher photoelectric conversion efficiency.

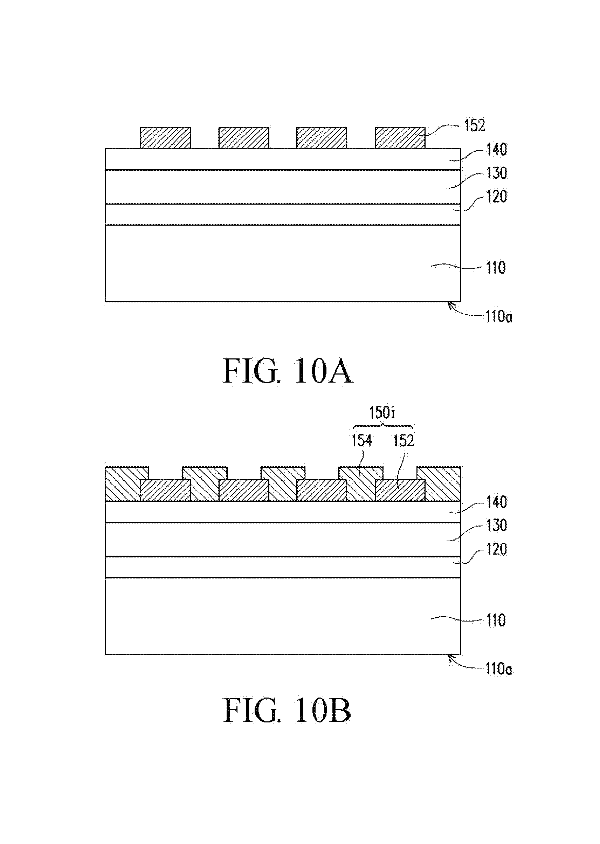

**FIGs. 10A** to **10C** are schematic cross-sectional views illustrating a manufacturing process of a thin-film solar cell according to another embodiment of the present invention. The process of forming the thin-film solar cell **100i** is similar to that of forming the thin-film solar cell **100g,** and differences therebetween will be described below.

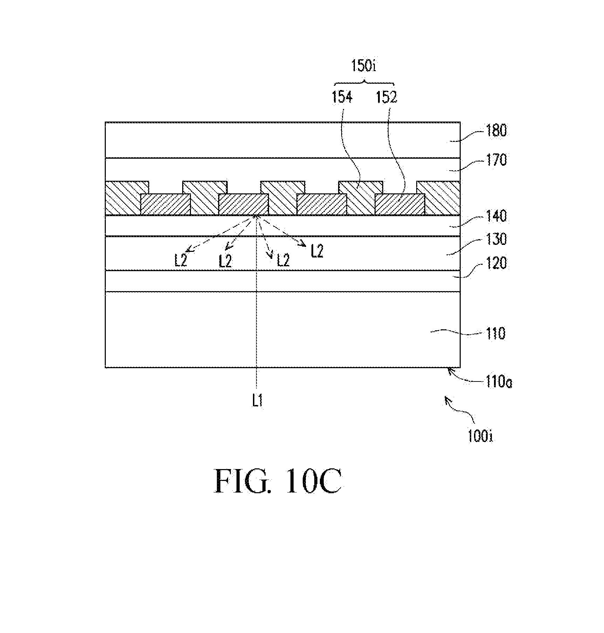

Referring to **FIG. 10A****,** after the second transparent conductive layer **140** is formed on the photovoltaic layer **130,** a first sub-pattern structure **152** exposing portions of the second transparent conductive layer **140 is** imprinted on the second transparent conductive layer **140.** Then, a second sub-pattern structure **154** is imprinted on the first sub-pattern structure **152.** The second sub-pattern structure **154** at least partially overlaps the first sub-pattern structure **152** to form a light reflecting structure **150i,** as shown in **FIG. 10****B.** Thereafter, as shown in **FIG. 10B****,** the adhesive layer **170** is applied onto the light reflecting structure **150i** to package the counter transparent substrate **180** and the transparent substrate **110** together, thus completing the fabrication of the thin-film solar cell **100i.**

It is worth noting that, in this embodiment, the patterned structure **150i** is, for example, of a check form formed by orthogonal intersection of the first sub-pattern structure **152** and the second sub-pattern structure **154** as shown in **FIG 2A****;** a rhombus form formed by intersection of the first sub-pattern structure **152** and the second sub-pattern structure **154** at an angle as shown in **FIG. 2B**; a straight stripe form (shown in **FIG. 2C**), a regular or irregular stripe form (not shown) or a transverse stripe form (not shown) formed by parallel arrangement and partial overlapping between the first sub-pattern structure **152** and the second sub-pattern structure **154**; or a mosaic form (shown in **FIG. 2D**) or a honeycomb form (not shown) formed through regular or irregular arrangement of the first sub-pattern structure **152** and the second sub-pattern structure **154**. In other words, the arrangement and structures of the first sub-pattern structure **152** and the second sub-pattern structure **154** can be varied depending on the user's requirements; and what described above is only for illustration purpose but is not to limit the present invention.

In this embodiment, the stack structure formed by the first sub-pattern structure **152** and the second sub-pattern structure **154** can affect the propagation direction of the light beam **L1** in such a way that the light beam **L1** is reflected and scatted at the interface between the light reflecting structure **150i** and the second transparent conductive layer **140** to form a light beam **L2.** This increases the opportunity for the light beam **L1** to be reflected in the thin-film solar cell **100i** and, consequently, prolongs the light path of the light beam **L2** in the photovoltaic layer **130** so that the light beam **L2** will be more likely be absorbed by the photovoltaic layer **130.** In this way, the thin-film solar cell **100i** can effectively absorb the light beam **L1** and convert it into electric energy, thus resulting in higher photoelectric conversion efficiency.

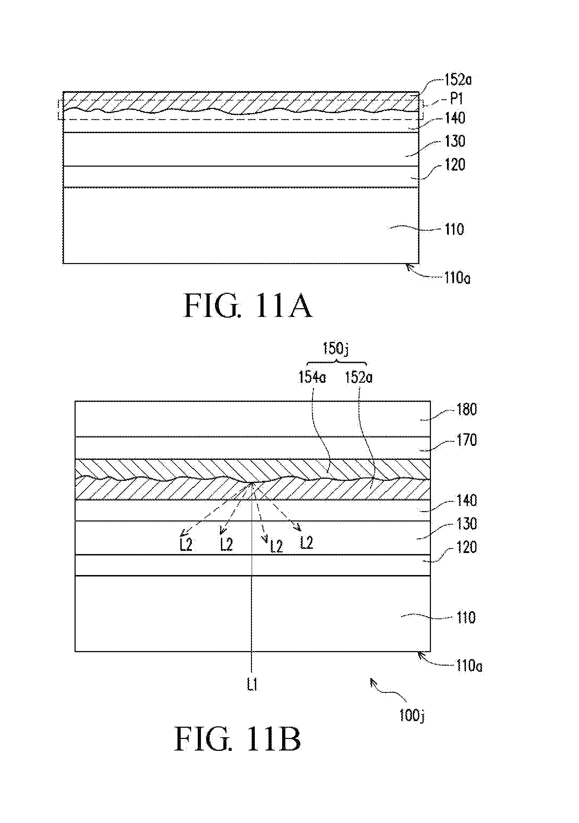

**FIGs. 11A** and **11B** are schematic cross-sectional views illustrating a manufacturing process of a thin-film solar cell according to another embodiment of the present invention. The process of forming the thin-film solar cell **100j** is similar to that of forming the thin-film solar cell **100i,** and differences therebetween will be described below.

Referring to **FIG 11A,** before impressing the first sub-pattern structure **152a** on the second transparent conductive layer **140,** a texture structure **P1** is formed on the first sub-pattern structure **152a.** The texture structure **P1** is disposed on a surface where the first sub-pattern structure **152a** makes contact with the second transparent conductive layer **140.** Here, the first sub-pattern structure **152a** covers the second transparent conductive layer **140** entirely. Then as shown in **FIG. 11B****,** sequentially, the second sub-pattern structure **154a** is imprinted on the first sub-pattern structure **152a** and the adhesive layer **170** is applied onto the second sub-pattern structure **154a** to package the counter transparent substrate **180** and the transparent substrate **110** together, thus completing the fabrication of the thin-film solar cell **100j.** Here, the second sub-pattern structure **154a** covers the first sub-pattern structure **152a** entirely, and the stack structure formed by the first sub-pattern structure **152a** and the second sub-pattern structure **154a** may be viewed as a light reflecting structure **150j.**

In this embodiment, the surface where the first sub-pattern structure **152a** makes contact with the second transparent conductive layer **140** is a texture structure **P1** which is, for example, a surface microstructure formed on the surface of the first sub-pattern structure **152a.** Of course, in other embodiments not shown, the texture structure **P1** may also be a surface microstructure formed on the surface of the second transparent conductive layer **140.** Additionally, in an embodiment not shown, a surface where the second sub-pattern structure makes contact with the first sub-pattern structure may also be a texture structure, which may be a surface microstructure formed on either the first sub-pattern structure or the second sub-pattern structure, although the present invention is not limited thereto.

Because the surface where the first patterned structure **152a** makes contact with the second transparent conductive layer **140** is the texture structure **P1,** it becomes easier for the light beam **L1** propagating to the texture structure **P1** to be reflected by the texture structure **P1** and for the reflected light beam **L2** to be scattered. This can prolong the light path of the light beam **L2** in the photovoltaic layer **130** and, consequently, increase the opportunity for the light beam **L2** to be absorbed by the photovoltaic layer **130,** thus improving the overall photoelectric conversion efficiency. Furthermore, the part **L2** of the light beam **L1** can be reflected directly by the light reflecting structure **150j** to the photovoltaic layer **130.** In other words, the first sub-pattern structure **152a** and the second sub-pattern structure **154a** can affect the propagation direction of the light beam **L1** in such a way that the light beam L1 is reflected and scattered by the surface where the first sub-pattern structure **152a** makes contact with the second transparent conductive layer **140** or in such a way that the light beam **L1** is reflected by the second patterned structure **154.** In this way, the opportunity for the light beam **L1** to be reflected in the thin-film solar cell **100j** can be increased to prolong the light path of the light beam **L1** in the photovoltaic layer **130** so that the light beam **L1** will be more likely absorbed by the photovoltaic layer **130** to generate more electron-hole pairs. Therefore, the thin-film solar cell **100j** can effectively enhance the utilization factor of the light beam **L1** to improve the photoelectric conversion efficiency thereof.

It is worth noting that, in an embodiment not shown, the light reflecting structure may also be a poly-layer formed by a plurality of first polymer materials and a plurality of second polymer materials alternately arranged. The first polymer materials are, for example, hydroxyl acetoxylated polyethylene terephtalate (PET) or a copolymer of hydroxyl acetoxylated polyethylene terephthalate, and the second polymer materials are, for example, polyethylene naphthalate (PEN) or a copolymer of polyethylene naphthalate. However, the materials described above are only provided as examples, and materials that can have the light reflecting structure **150j** reflect the light beam all fall within the scope of the present invention.

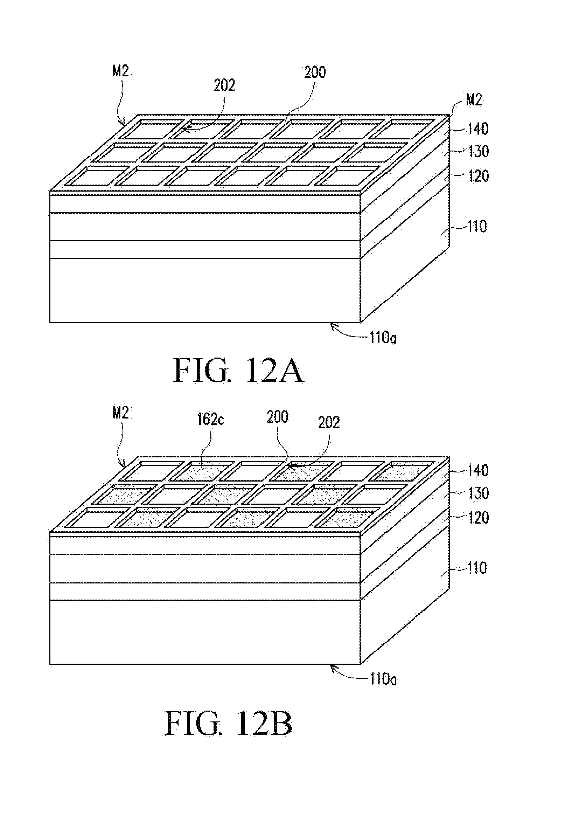

**FIGs. 12A** to **12D** are schematic cross-sectional views illustrating a manufacturing process of a thin-film solar cell according to another embodiment of the present invention. The process of forming the thin-film solar cell **100k** is similar to that of forming the thin-film solar cell **100g,** and differences therebetween will be described below.

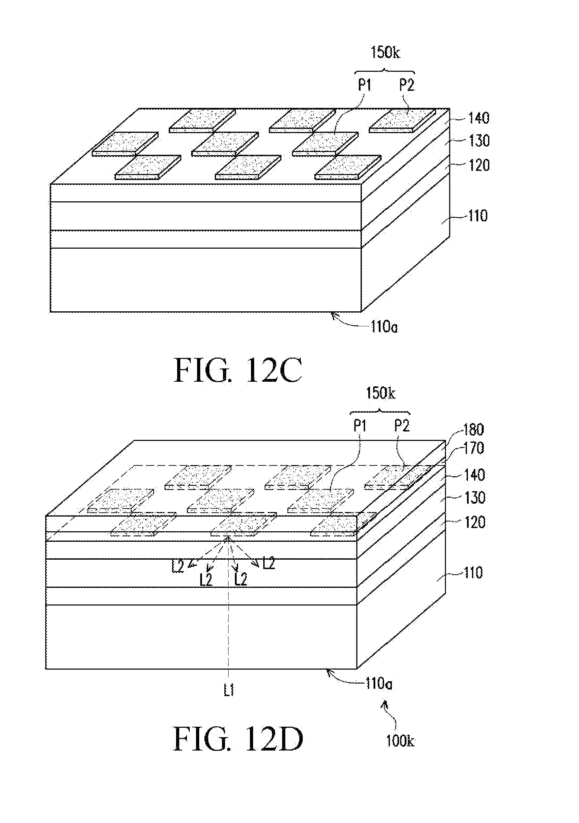

Referring to **FIG. 12A****,** after the second transparent conductive layer **140** is formed, a mold **M2** having a mesh pattern **200** is disposed on the second transparent conductive layer **140.** The mesh pattern **200** has a plurality of openings **202** exposing the second transparent conductive layer **140.** Next, as shown in **FIG. 12B****,** a reflective material layer **162c** is formed on the mold **M2**, with portions of the reflective material layer **162c** being filled into the openings **202** to connect with the second transparent conductive layer **140.** Next, as shown in **FIG 12C****,** the mold **M2** is removed to form a light reflecting structure **150k** having a texture structure **P2.** Afterwards, as shown in **FIG. 12D****,** the adhesive layer **170** is applied onto the light reflecting structure **150k** to package the counter transparent substrate **180** and the transparent substrate **110** together, thus completing the fabrication of the thin-film solar cell **100k**.

In brief, this embodiment forms the light reflecting structure **150k** through a mesh process. The reflective material layer **162c** can be filled into the openings **202** randomly through the mesh pattern **200** to form on the second transparent conductive layer **140** the light reflecting structure **150k** having the texture structure **P2.** Owing to the texture structure **P2** of the light reflecting structure **150k,** the opportunity for the light beam **L1** to be reflected and scattered in thin-film solar cell **100k** can get increased. This prolongs the light path of the light beam **L2** in the photovoltaic layer **130** and, consequently, increases the opportunity for the light beam **L2** to be absorbed by the photovoltaic layer **130** to generate more electron-hole pairs. In this way, the thin-film solar cell **100k** can effectively enhance the utilization factor of the light beam **L1,** thus resulting in higher photoelectric conversion efficiency thereof.

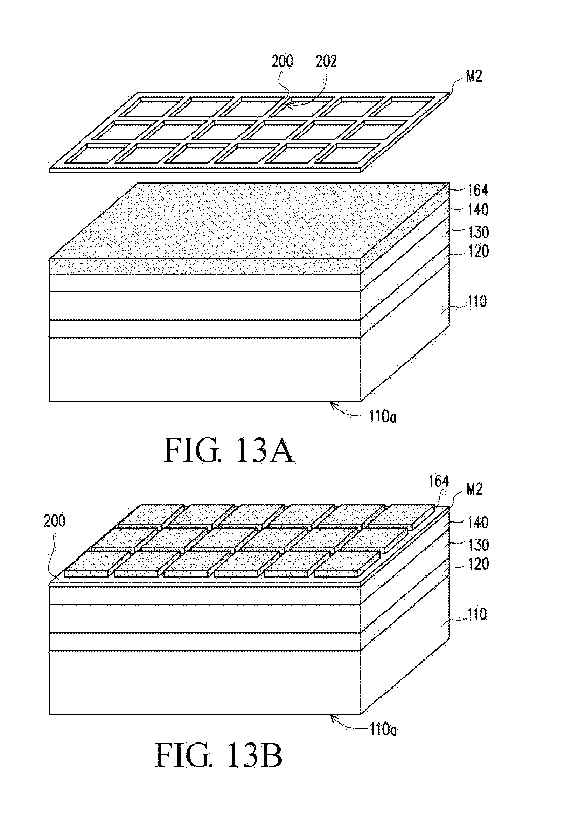

**FIGs. 13A** to **13D** are schematic cross-sectional views illustrating a manufacturing process of a thin-film solar cell according to another embodiment of the present invention. The process of forming the thin-film solar cell **1001** is similar to that of forming the thin-film solar cell **100k,** and differences therebetween will be described below.

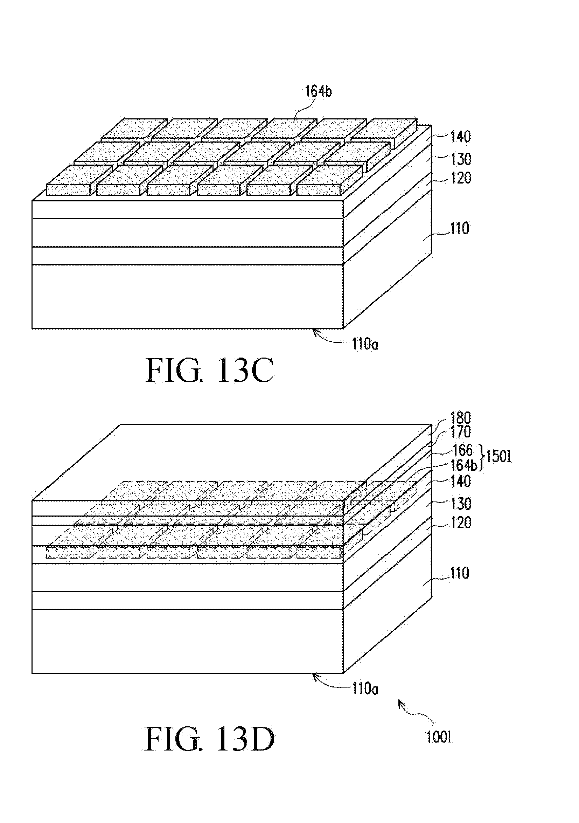

Referring to **FIG. 13A****,** after the second transparent conductive layer **140** is formed, a transparent material layer **164** is formed on the second transparent conductive layer **140** entirely. Then, as shown in **FIG. 13B****,** a mold **M2** having the mesh pattern **200** is impressed onto the transparent material layer **164.** Next, as shown in **FIG. 13C****,** after curing of the transparent material layer **164b,** the mold **M2** is removed to form a mesh pattern **200** on the surface of the transparent material layer **164b.** Afterwards, as shown in **FIG. 13D****,** a reflective material layer **166** is formed on the transparent material layer **164b.** The reflective material layer **166** covers the entire transparent material layer **164b** and portions of the second transparent material layer **140.** Here, the stack structure formed by the transparent material layer **164b** and the reflective material layer **166** can be viewed as a light reflecting structure **1501.** Then, as shown in **FIG. 13D****,** the adhesive layer **170 is** applied onto the light reflecting structure **1501** to package the counter transparent substrate **180** and the transparent substrate **110** together, thus completing the fabrication of the thin-film solar cell **1001.**

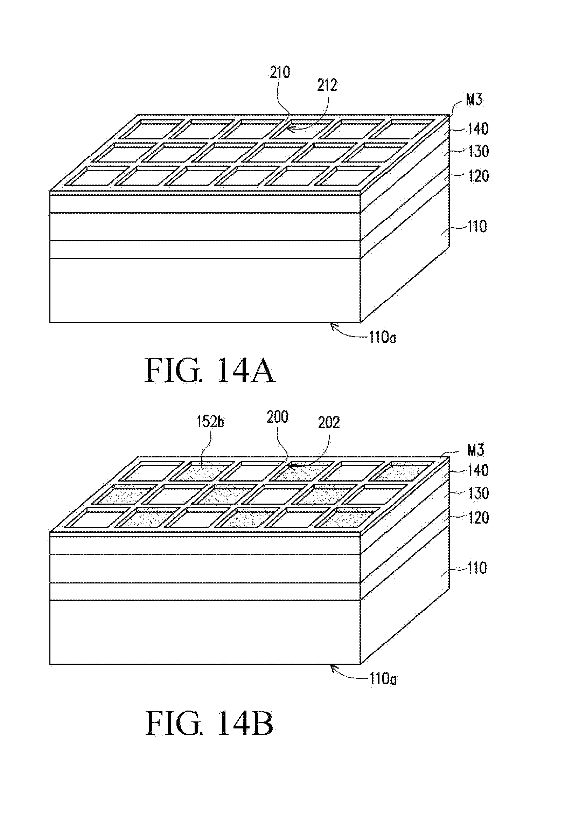

**FIGs. 14A** to **14E** are schematic cross-sectional views illustrating a manufacturing process of a thin-film solar cell according to another embodiment of the present invention. The process of forming the thin-film solar cell **100m** is similar to that of forming the thin-film solar cell **100k,** and differences therebetween will be described below.

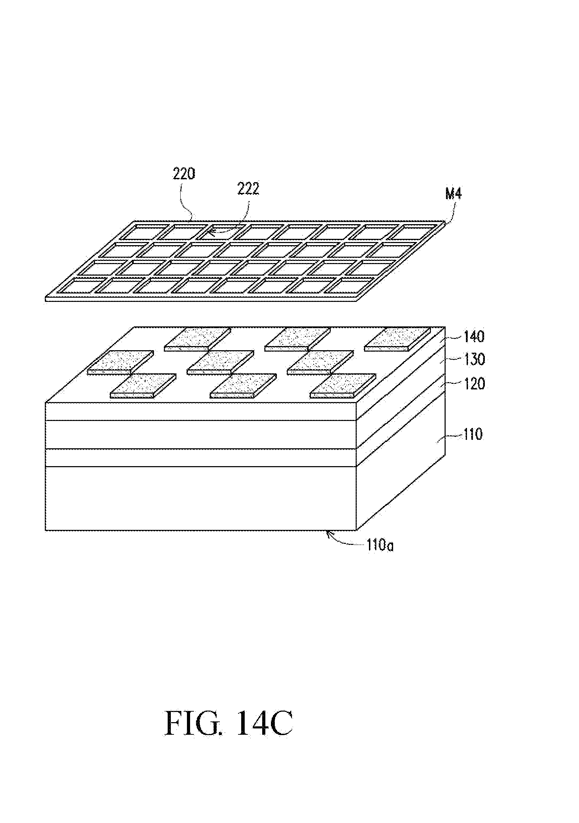

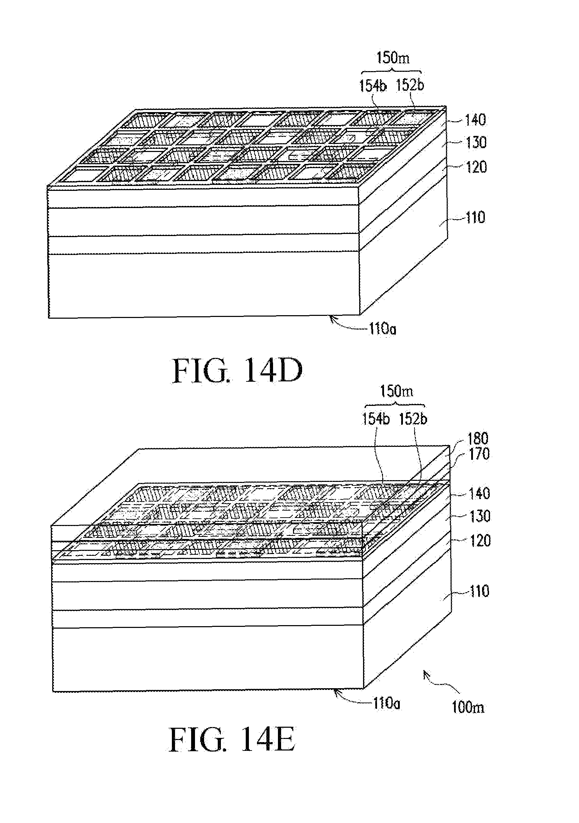

Referring to **FIG. 14A****,** after the second transparent conductive layer **140** is formed, a first mold **M3** having a first mesh pattern **210** is disposed on the second transparent conductive layer **140.** The first mesh pattern **210** has a plurality of openings **212** exposing the second transparent conductive layer **140.** Next, as shown in **FIG. 14B****,** a first sub-patterrn structure **152b** is formed on the first mold **M3,** with the first sub-pattern structure **152b** being connected with portions of the second transparent conductive layer **140.** Next, as shown in **FIG. 14C****,** after curing of the first sub-pattern structure **152b,** the first mold **M3** is removed and a second mold **M4** having a second mesh pattern **220** is disposed on the first sub-pattern structure **152b.** The second mesh pattern **220** has a plurality of second openings **222** that expose at least portions of the first openings **212.** Thereafter, as shown in **FIG. 14D****,** a second sub-pattern structure **154b** is formed on the first sub-pattern structure **152b.** The second sub-pattern structure **154b** at least partially overlaps the first sub-pattern structure **152b** to form a light reflecting structure **150m.** Finally, as shown in **FIG. 14E****,** the adhesive layer **170** is applied onto the light reflecting structure **150m** to package the counter transparent substrate **180** and the transparent substrate **110** together, thus completing the fabrication of the thin-film solar cell **100m.**

Of course, the aforesaid methods for manufacturing thin-film solar cells are only illustrated as examples, and some of the steps are common in the art. Depending on practical conditions, alterations, omissions or additions may be made on the steps by those skilled in the art to meet practical process requirements, which will not be further described herein. Furthermore, in other embodiments not shown, the aforesaid elements can be optionally selected by those skilled in the art, based on the descriptions of the aforesaid embodiments, to achieve the desired technical effect depending on practical requirements.

According to the above descriptions, the methods for manufacturing a thin-film solar cell of the present invention form a light reflecting structure having a texture structure on the second transparent conductive layer to increase the opportunity for the light beam to be reflected in the thin-film solar cell. This can prolong the light path of the light beam in the photovoltaic layer so that the light beam will be more likely absorbed by the photovoltaic layer to generate more electron-hole pairs. In other words, the methods for manufacturing a thin-film solar cell of the present invention can effectively enhance the utilization factor of the light beam to improve the photoelectric conversion efficiency of the resulting thin-film solar cell.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A thin-film solar cell, comprising:
a transparent substrate, having a light incident surface and a light exiting surface
opposite to the light incident surface;
a first transparent conductive layer, being disposed on the light exiting surface of the
transparent substrate;
a photovoltaic layer, being disposed on the first transparent conductive layer;
a second transparent conductive layer, being disposed on the photovoltaic layer; and
a light reflecting structure, being disposed on the second transparent conductive layer;
wherein a light beam enters the thin-film solar cell via the light incident surface, passes
sequentially through the transparent substrate, the first transparent conductive layer, the photovoltaic layer and the second transparent conductive layer and then into the light reflecting structure, and the light reflecting structure reflects the light beam.

2. The thin-film solar cell as claimed in claim 1, wherein the light reflecting structure comprises a patterned structure having a first sub-pattern structure and a second sub-pattern structure, the first sub-pattern structure is disposed on the second transparent conductive layer and the second sub-pattern structure is disposed on the first sub-pattern structure, and the second sub-pattern structure at least partially overlaps the first sub-patten structure.

3. The thin-film solar cell as claimed in claim 2, wherein a surface where the first sub-pattern structure makes contact with the second transparent conductive layer is a texture structure.

4. The thin-film solar cell as claimed in claim 2, wherein at least a surface where the second sub-pattern structure makes contact with the first sub-pattern structure is a texture structure.

5. The thin-film solar cell as claimed in claim 1, wherein the light reflecting structure is a light reflecting structure layer, and the light reflecting structure layer is integrally formed.

6. The thin-film solar cell as claimed in claim 5, wherein the light reflecting structure layer entirely or partially covers the second transparent conductive layer.

7. The thin-film solar cell as claimed in claim 6, wherein a surface where the light reflecting structure layer makes contact with the second transparent conductive layer is a texture structure.

8. A method for manufacturing a thin-film solar cell, comprising:
providing a transparent substrate;
forming a first transparent conductive layer on the transparent substrate;
forming a photovoltaic layer on the first transparent conductive layer;
forming a second transparent conductive layer on the photovoltaic layer; and
forming a light reflecting structure having a texture structure on the second transparent
conductive layer,

9. The method for manufacturing a thin-film solar cell as claimed in claim 8, wherein the light reflecting structure is formed through one of an impression process and a mesh process.

10. The method for manufacturing a thin-film solar cell as claimed in claim 9, wherein the impression process comprises:
forming a reflective material layer on the second transparent conductive layer entirely;
and
impressing a mold with a texture pattern onto the reflective material layer to form the
light reflecting structure having the texture structure.

11. The method for manufacturing a thin-film solar cell as claimed in claim 9, wherein the impression process comprises:
forming a transparent material layer on the second transparent conductive layer entirely;
impressing a mold with a texture pattern onto the transparent material layer to form the
texture structure on the surface of the transparent material layer; and
forming a reflective material layer on the transparent material layer.

12. The method for manufacturing a thin-film solar cell as claimed in claim 9, wherein the impression process comprises:
impressing a first sub-pattern structure on the second transparent conductive layer; and
impressing a second sub-pattern structure on the first sub-pattern structure;
wherein the second sub-pattern structure at least partially overlaps the first sub-pattern
structure to form the light reflecting structure.

13. The method for manufacturing a thin-film solar cell as claimed in claim 9, wherein the mesh process comprises:
disposing a mold having a mesh pattern on the second transparent conductive layer,
wherein the mesh pattern has a plurality of openings exposing the second transparent conductive layer;
forming a reflective material layer on the mold, wherein portions of the reflective
material layer is filled into the openings to connect to the second transparent conductive layer; and
removing the mold to form the light reflecting structure having the texture structure.

14. The method for manufacturing a thin-film solar cell as claimed in claim 9, wherein the mesh process comprises:
forming a transparent material layer on the second transparent conductive layer entirely;
impressing a mold with a mesh pattern onto the transparent material layer to form the
mesh pattern on a surface of the transparent material layer;
removing the mold; and
forming a reflective material layer on the transparent material layer.

15. The method for manufacturing a thin-film solar cell as claimed in claim 9, wherein the mesh process comprises:
disposing a first mold with a first mesh pattern on the second transparent conductive
layer, wherein the first mesh pattern has a plurality of first openings exposing the second transparent conductive layer;
forming a first sub-pattern structure on the first mold, wherein the first sub-pattern
structure connects with portions of the second transparent conductive layer;
disposing a second mold with a second mesh pattern on the first sub-pattern structure,
wherein the second mesh pattern has a plurality of second openings exposing at least portions of the first openings; and
forming a second sub-pattern structure on the first sub-pattern structure, wherein the
second sub-pattern structure at least partially overlaps the first sub-pattern structure to form the light reflecting structure.
